(19) Europäisches Patentamt

European Patent Office

Office européen des brevets

(11)  **EP 1 547 242 B1**

(12)  **EUROPEAN PATENT SPECIFICATION**

(45) Date of publication and mention
of the grant of the patent:
**30.07.2008 Bulletin 2008/31**

(51) Int Cl.:
**H03G 3/00** *(2006.01)*  **H03G 3/30** *(2006.01)*

(21) Application number: **03798292.3**

(22) Date of filing: **15.09.2003**

(86) International application number:
**PCT/IB2003/004054**

(87) International publication number:
**WO 2004/030247 (08.04.2004 Gazette 2004/15)**

(54)  **DEVICE AND METHOD FOR DETERMINING THE LEVEL OF AN INPUT SIGNAL INTENDED TO BE APPLIED TO A RECEIVING SYSTEM**

EINRICHTUNG UND VERFAHREN ZUR BESTIMMUNG DES PEGELS EINES EINGANGSSIGNALS, DAS AN EIN EMPFANGSSYSTEM ANGELEGT WERDEN SOLL

DISPOSITIF ET PROCEDE PERMETTANT DE DETERMINER LE NIVEAU D'UN SIGNAL D'ENTREE DESTINE A ETRE APPLIQUE A UN SYSTEME DE RECEPTION

(84) Designated Contracting States:
**AT BE BG CH CY CZ DE DK EE ES FI FR GB GR HU IE IT LI LU MC NL PT RO SE SI SK TR**

(30) Priority: **25.09.2002 FR 0211838**

(43) Date of publication of application:
**29.06.2005 Bulletin 2005/26**

(73) Proprietor: **NXP B.V.**
**5656 AG Eindhoven (NL)**

(72) Inventors:
• **SENESCHAL, François**
**F-75008 Paris (FR)**
• **MAUPAS, Alexandre**
**F-75008 Paris (FR)**

(74) Representative: **White, Andrew Gordon et al**
**NXP Semiconductors**
**Intellectual Property Department**
**Cross Oak Lane**
**Redhill, Surrey RH1 5HA (GB)**

(56) References cited:
**US-A- 5 129 098          US-A- 6 107 878**
**US-B1- 6 353 364**

• **PATENT ABSTRACTS OF JAPAN & JP 11 331288 A (FUJITSU GENERAL LTD), 30 November 1999 (1999-11-30)**

**Description**

**FIELD OF THE INVENTION**

The invention relates to a device for determining the level of an input signal intended to be applied to a receiving system, said receiving system comprising arranged in series a set of discrete gain amplifiers, a selective filter, a mixer, said receiving system being intended to deliver an output signal.
The invention has numerous applications in appliances intended to receive a radio-frequency signal (RF) whose level is to be determined.

**BACKGROUND OF THE INVENTION**

The development of cable networks implies to establish a fast diagnosis of installations of which the service providers are in charge and in control.
In order to be able to rapidly verify the cable system at the level of each user, that is to say, at the level of the receiving systems, the receiving systems (for example a so-called set top box or cable modem comprising a tuner) are to have the RSSI functionality (Received Signal Strength Indicator) in conformity with American standard DOCSIS V1.1.
This functionality allows determining with an absolute precision of $\pm$ 3 dB and a relative precision of $\pm$ 0.5 dB (relative to a signal of known level sent by the service provider), the level of the input signal which is applied to the receiving system.
Once the level of the input signal has been determined, it is sent to the service provider to perform a diagnostic.
US patent US 6,107,878 describes an automatic gain control signal in which a received signal strength is estimated by a received signal strength indicator (RSSI) circuit based on the total gain of the chain of amplifiers and filters between the signal input and the RSSI circuit. A sum circuit generates a further signal indicative of the difference between a reference signal strength and the strength of the received signal. The further signal is used to control a generic gain control circuit, which is used to distribute gain adjustments over the amplifiers in said chain in response to the further signal.
From the state of the art are also known devices for determining the level of an input signal intended to be applied to a receiving system. These devices implement calibration tables stored in a memory defining the characteristic features of all the components used.
These known devices have a certain number of limitations in so far as the calibration tables are to be recalculated for each component, which renders the manufacture of such devices costly, considering the time necessary for the calibration.
On the other hand, these tables store many data, which implies that an additional memory of the EPROM type is used, which increases the cost price and the size of the device.
Finally, at the end of the manufacturing process, these devices are often not compliant with the DOCSIS V1.1 standard because they do not respect the precision of the input signal that is determined. A costly selection from all these devices is thus to be made to select only the compliant devices.

**OBJECT AND SUMMARY OF THE INVENTION**

It is an object of the invention to propose a low-cost device which is in conformity with the DOCSIS standard for determining the level of an input signal intended to be applied to a receiving system.
To this end, the device according to the invention comprises :

-    measuring means for measuring the level of said output signal in a given frequency channel,
-    means for determining the real gain of said set of amplifiers in said given frequency channel,
-    means for determining the real gain of said selective filter in said given frequency channel,
-    calculation means for deriving the level of the input signal from the level of the output signal, the real gain of said set of amplifiers and from the real gain of said selective filter.

The device measures an output signal in the desired frequency channel and determines the total gain of both amplifiers and selective filter. When the level of the output signal and the gain is expressed in Decibels (dB), the level of the input signal is simply derived by a subtraction between the output signal level and said total gain, which constitutes a cost-effective solution.
In a preferred embodiment, the real gain of said selective filter is given by a set of equations defined by a set of coefficients depending on said frequency channel.
A few coefficients are used for defining the equations, which permits to store them no longer in a specific memory of the EPROM type but in the general memory of the receiving system.

In a preferred embodiment, the device according to the invention comprises additional means for averaging the level of said output signal.

This additional characteristic allows decreasing the noise contained in the output signal, which permits to precisely determine the level of the input signal.

In a preferred embodiment, the device according to the invention comprises additional means for rounding the level of said input signal to the nearest half value.

This additional characteristic permits to statistically enhance the precision of the level of the input signal and thus to reduce the measuring error.

In a preferred embodiment, the real gain of said set of amplifiers is given by a look-up table with two inputs, a first input corresponding to said given frequency channel, a second input corresponding to the nominal gain of said amplifiers.

The look-up table permits to know the real gain of each amplifier, which permits to precisely derive the level of the input signal.

The number of coefficients stored in the look-up table is limited, which permits to store them no longer in a specific EPROM-type memory but in the memory of the receiving system.

In a preferred embodiment, said measuring means comprise arranged in series a selective filter for selecting said given frequency channel, a logarithmic detector and an analog-to-digital converter for delivering the level of said output signal in said given frequency channel.

This additional characteristic allows generating a digital value of the output signal level which is expressed in Decibels, which value can directly be used for determining the level of the input signal.

The invention also relates to a method for determining, in accordance with the DOCSIS standard, the level of an input signal intended to be applied to a receiving system. For this purpose the steps of this method correspond to the functions of the various processing means used in the device according to the invention described earlier.

The invention also relates to a receiving system of the multimedia signal set-top box type or the modem type comprising a tuner, the receiving system comprising a device as described earlier for determining the level of the input signal applied to its input.

The invention also relates to a signal generated by the device or the method according to the invention. This signal corresponds to the determined level of the input signal, and implicitly comprises technical characteristics of said device and method.

The invention also relates to a computer program product comprising instruction codes for implementing one or a plurality of steps of the method mentioned above. These instruction codes are intended to be stored in a memory and executed by a signal processor.

## BRIEF DESCRIPTION OF THE DRAWINGS

These and other aspects of the invention are apparent from and will be elucidated, by way of non-limitative example, with reference to the embodiment(s) described hereinafter. In the drawings:

Fig.1 describes a receiving system comprising a device in accordance with the invention,
Fig.2 represents the flow chart of the steps of the method according to the invention,
Fig.3 illustrates the gain variations of a selective filter.

## DETAILED DESCRIPTION OF THE INVENTION

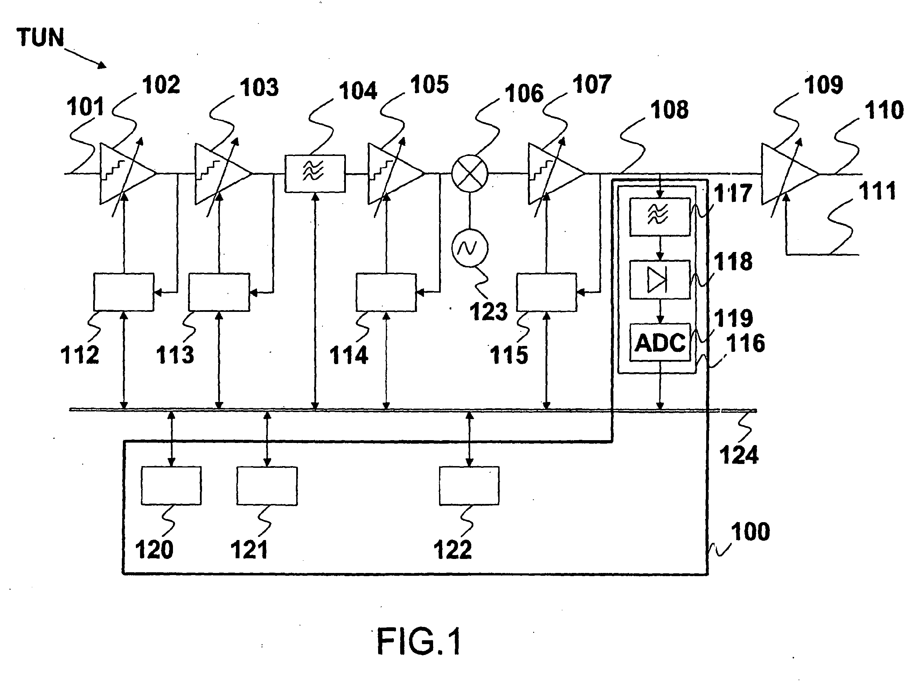

Fig.1 describes a receiving system comprising a tuner TUN, and a device 100 according to the invention. The receiving system receives on its input a radio-frequency (RF) signal 101 whose level for a given frequency channel is determined by the device 100 according to the invention. The receiving system comprises arranged in series :

- an amplifier 102 receiving the input signal 101, whose nominal gain is defined by a control device 112 via the sending of a digital control word,
- an amplifier 103 whose nominal gain is defined by a control device 113 via the sending of a digital control word,
- a selective filter 104 intended to suppress high-order harmonics in the input signal 101,
- an amplifier 105 whose nominal gain is defined by a control device 114 via the sending of a digital control word,
- a mixer 106 for performing a frequency change in the amplified input signal 101 via a multiplication of a periodic signal coming from an oscillator 123,
- an amplifier 107 delivering an output signal 108 whose nominal gain is defined by a control device 115 via the sending of a digital control word,
- an amplifier 109 delivering an output signal 110 of a constant level, whose gain is defined by a control signal 111.

The device 100 according to the invention is connected to the receiving system via a data bus 124, for example an I$^2$C bus. The device 100 comprises :

- measuring means 116 for measuring the level of said output signal 108 in a given frequency channel,
- means 120 for determining the cumulated gain of the amplifiers 102-103-105-107 in said given frequency channel,
- means 121 for determining the gain of said selective filter 104 in said given frequency channel,
- calculation means 122 for deriving said level of the input signal 101 from said output signal 108, from the cumulated gain of the amplifiers 102-103-105-107 and from the gain of said selective filter 104.

The measuring means 116 and processing means 120-121-122 communicate over the data bus 124.
The working principle of the device 100 is to measure the level of the output signal 108, to determine the real total gain via which the input signal 101 is amplified by the various amplifiers and filters arranged in series, and to derive the level of the input signal 101 from these values.
The real total gain via which the input signal 101 is amplified by the amplifiers 102-103-105-107 is given by a dual-input look-up table, a first input corresponding to the given frequency channel X, a second input corresponding to the nominal gain of said amplifiers. A non-limitative example of such a look-up table is given below :

|  | AGC1 (dB) | | | AGC2 (dB) | | | | | | AGC3 (dB) | | | AGC4 (dB) | | |
| --- | --- | --- | --- | --- | --- | --- | --- | --- | --- | --- | --- | --- | --- | --- | --- |
| F (MHz) | 4 | 8 | 12 | -6 | -2 | 2 | 6 | 10 | 14 | -8 | -4 | 0 | -6 | -3 | 0 |
| 0<X<420 | 4.1 | 8.1 | 12 | -5.7 | -1.7 | 2.3 | 6.3 | 10.2 | 14 | -7.8 | -3.8 | 0 | -5.8 | -2.9 | 0 |
| 420<X<840 | 3.9 | 7.9 | 12 | -5.9 | -2 | 2 | 6.2 | 10.1 | 14 | -7.7 | -3.9 | 0 | -5.8 | -2.9 | 0 |
| X>840 | 4.5 | 8.2 | 12 | -4.8 | -1 | 2.9 | 6.9 | 10.7 | 14 | -7.3 | -3.5 | 0 | -5.8 | -2.9 | 0 |

The parameter X corresponds to the frequency channel for which the input signal is determined by the device 100 according to the invention. The first row of the columns AGC1-AGC2-AGC3-AGC4 corresponds to the nominal gains of the amplifiers 102-103-105-107, fixed by the control devices 112-113-14-115, respectively.
The values of these nominal gains are sent to the means 120 by each of the amplifiers over the data bus 124. For each amplifier, the means 120 are in charge of putting the value of a nominal gain and the frequency channel X into correspondence for determining the real gain of the amplifier, said real gain being given by the coefficients of the dual-input look-up table. The coefficients of the look-up table are derived from a calibration previously carried out on each amplifier, and then stored in a memory (not shown).
Once the real gain of each amplifier is known, a sum of these real gains is done by the means 120 to determine the total gain of the set of amplifiers.
In parallel, the real gain of the selective filter 104 is determined by the means 121. The selective filter 104 indicates to the means 121 the value of the frequency channel X. A set of equations depending on the frequency range in which the frequency channel X is situated allows determining the real gain of the selective filter. The coefficients of this set of equations derive from a calibration previously made on the selective filter 104. A non-limitative example of such a set of equations is given below.

$$\text{Equation 1 : } 0<X<420 \text{ MHz}$$

$$-7{,}0258*10^{-8}\,X^4 + 5{,}0247*10^{-5}\,X^3 - 1{,}3011*10^{-2}\,X^2 + 1{,}1268^{\bullet}X - 30{,}8 \qquad \text{Eq.1}$$

$$\text{Equation 2 : } 420<X<840 \text{ MHz}$$

$$-1{,}6317*10^{-11}\,X^4 + 3{,}0699*10^{-7}\,X^3 - 4{,}9971*10^{-4}\,X^2 + 0{,}24851^{\bullet}X - 43{,}94 \qquad \text{Eq.2}$$

### Equation 3 : X>840 MHz

$$-6{,}3403*10^{-10}\,X^4 + 1{,}666*10^{-6}\,X^3 - 1{,}6353*10^{-3}\,X^2 + 0{,}70595\cdot X - 122{,}85 \qquad \text{Eq.3}$$

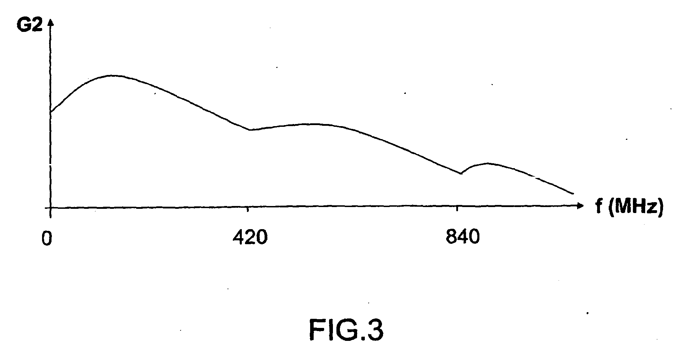

Fig.3 illustrates the corresponding variations of the gain G2 of the selective filter 104.

By adding real gains of the amplifiers and the selective filter, the calculation means 122 determine the real total gain by which the input signal 101 has been amplified by the various amplifiers and filters arranged in series.

Preferably, the level of the output signal 108 and the gains of the amplifiers and of the selective filter are expressed in Decibels (dB) so that the level of the input signal 101 is obtained by simple subtraction of the level of the output signal 108 and the value of said real total gain.

For making a direct measurement in Decibels, the measuring means 116 comprise arranged in series :

- a selective filter 117 for selecting said given frequency channel,
- a logarithmic detector 118 for delivering an output value proportional to the logarithm of the signal present on its input,
- an analog-to-digital converter 119 for delivering the level of said output signal in said given frequency channel.

For reducing the noise present in the output signal 108, for example due to the spectral noise, various successive measurements are made by the measuring means 116. Each of these measurements is for example temporarily stored, then an average of these measurements is calculated for delivering an averaged measurement of the output signal 108 in the given frequency channel containing a low noise level. Such an average of these values may be made, for example, by instruction codes executed by a signal processor.

For reducing measuring errors and for statistically increasing the precision in the level determination of an input signal 101, the level of the input signal is rounded to the nearest half value. These rounding may, for example, be made by instruction codes executed by a signal processor.

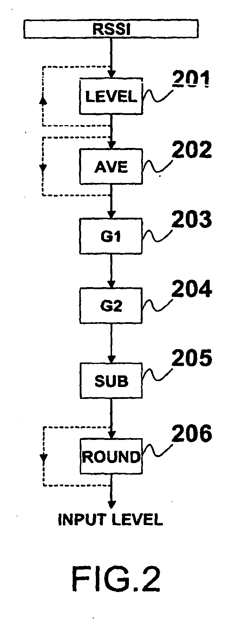

Fig.2 represents the flow chart of the steps of the method according to the invention for determining the level of the input signal 101 applied to a receiving system represented in Fig.1. This method comprises:

- a measuring step 201 for measuring the level of the output signal 108 in a given frequency channel. This measuring step is repeated several times consecutively if an average value of this output signal is desired.
- a calculation step 202 for calculating the average of the set of values measured in step 201,
- a processing step 203 for determining from a look-up table the real total gain G1 of the set of amplifiers. The real total gain corresponds to the addition of real gains of each amplifier.
- a first calculation step 204 for determining the real gain G2 of the selective filter 104 from a set of equations depending on the frequency channel,
- a second calculation step 205 for deriving the level of the input signal 101 from the gains G1 and G2, and from the level of the output signal 108 measured during the step 201. If the gains and the level of the output signal are expressed in Decibels, the calculation step 205 consists of subtracting the gains G1 and G2 from the level of the measured signal 108.
- a step 206 for rounding the level of the input signal 101 determined by the step 205 to the nearest half value.

The signal which is generated by the device or the method according to the invention corresponds to the determined level of the input signal. This signal is sent to service provider. This signal implicitly comprises technical characteristics of said device and method according to the invention.

The invention is not restricted to the measurement of the level of an input signal applied to a tuner receiving system as described in Fig.1. Indeed, the device and the method according to the invention may also be implemented in a receiving system comprising a different number of amplifiers and selective filters. Similarly, the selective filter may be determined by a set of equations comprising a different number of equations depending on the frequency channel, the equations being defined by coefficients that can be recalibrated to take specific characteristics of the selective filter into account.

The device according to the invention may be implemented in any receiving system comprising an RSSI functionality for measuring and sending to a service provider, the level of the input signal applied to its input. For example, the device according to the invention can be implemented in a set top box comprising a tuner for receiving multimedia signals or a cable modem comprising a tuner.

## Claims

1. Device for determining the level of an input signal (101) received by a receiving system (TUN), said receiving system (TUN) comprising arranged in series a set of discrete gain amplifiers (102-103-105-107), a selective filter (104), a mixer (106), said receiving system (TUN) being arranged to deliver an output signal (108), said device comprising:

   - measuring means (116) for measuring the level of said output signal (108) in a given frequency channel,
   - means (120) for determining the actual gain (G1) of said set of amplifiers (102-103-105-107) in said given frequency channel,
   - means (121) for determining the actual gain (G2) of said selective filter (104) in said given frequency channel by a set of equations whose coefficients are derived from a calibration made for each frequency range of said selective filter,
   - calculation means (122) for deriving the level of the input signal (101) from the level of the output signal (108), the actual gain (G1) of said set of amplifiers (102-103-105-107) and from the actual gain (G2) of said selective filter (104).

2. Device as claimed in claim 1 comprising additional means for averaging the level of said output signal (108).

3. Device as claimed in claim 2 comprising additional means for rounding the level of said input signal (101) to the nearest half value.

4. Device as claimed in claim 3 where the real gain (G1) of said set of amplifiers (102-103-105-107) is given by a look-up table with two inputs, a first input corresponding to said given frequency channel, a second input corresponding to the nominal gain of said amplifiers.

5. Device as claimed in claim 4 where said measuring means (116) comprise arranged in series a selective filter (117) for selecting said given frequency channel, a logarithmic detector (118) and an analog-to-digital converter (ADC) for delivering the level of said output signal (108) in said given frequency channel.

6. Method for determining the level of an input signal (101) received by a receiving system (TUN), said receiving system (TUN) comprising arranged in series a set of discrete gain amplifiers (102-103-105-107), a selective filter (104), a mixer (106), said receiving system (TUN) being arranged to deliver an output signal (108), said method comprising :

   - a measuring step (201) for measuring the level of said output signal (108) in a given frequency channel,
   - a processing step (203) for determining the actual gain (G1) of said set of amplifiers (102-103-105-107) in said given frequency channel,
   - a first calculation step (204) for determining the actual gain (G2) of said selective filter (104) in said given frequency channel by a set of equations whose coefficients are derived from a calibration made for each frequency range of said selective filter, and
   - a second calculation step (205) for deriving the level of the input signal (101) from the level of the output signal (108), from the actual gain (G1) of said set of amplifiers and from the actual gain (G2) of said selective filter (104).

7. Receiving box for multimedia signals, or modem comprising a device as claimed in anyone of claim 1 to 5.

8. Signal generated by the method as claimed in claim 6, said signal indicating the level of the input signal (101).

9. Computer program comprising instruction codes for executing one or a plurality of steps of the method as claimed in claim 6.

## Patentansprüche

1. Vorrichtung zur Bestimmung des Pegels eines durch ein Empfangssystem (TUN) empfangenen Eingangssignals (101), wobei das Empfangssystem (TUN) einen Satz von Verstärkern diskreter Verstärkung (102-103-105-107), ein Selektivfilter (104), eine Mischstufe (106) in Reihe angeordnet aufweist, das Empfangssystem (TUN) ausgebildet ist, ein Ausgangssignal (108) zu liefern, wobei die Einrichtung umfasst:

   - Messmittel (116) zur Messung des Pegels des Ausgangssignals (108) in einem gegebenen Frequenzkanal,

- Mittel (120) zur Bestimmung der tatsächlichen Verstärkung (G1) des Satzes von Verstärkern (102-103-105-107) in dem gegebenen Frequenzkanal,
- Mittel (121) zur Bestimmung der tatsächlichen Verstärkung (G2) des Selektivfilters (104) in dem gegebenen Frequenzkanal durch einen Satz von Gleichungen, deren Koeffizienten von einer für jeden Frequenzbereich des Selektivfilters vorgenommenen Kalibrierung abgeleitet sind,
- Berechnungsmittel (122) zur Ableitung des Pegels des Eingangssignals (101) von dem Pegel des Ausgangssignals (108), der tatsächlichen Verstärkung (G1) des Satzes von Verstärkern (102-103-105-107) und von der tatsächlichen Verstärkung (G2) des Selektivfilters (104).

2. Vorrichtung nach Anspruch 1, die zusätzliche Mittel zur Mittelwertbildung des Pegels des Ausgangssignals (108) aufweist.

3. Vorrichtung nach Anspruch 2, die zusätzliche Mittel zur Rundung des Pegels des Eingangssignals (101) auf den nächstliegenden halben Wert aufweist.

4. Vorrichtung nach Anspruch 3, bei der die reale Verstärkung (G1) des Satzes von Verstärkern (102-103-105-107) durch eine Verweistabelle mit zwei Eingaben, von denen eine erste Eingabe dem gegebenen Frequenzkanal, eine zweite Eingabe der nominellen Verstärkung der Verstärker entspricht, gegeben ist.

5. Vorrichtung nach Anspruch 4, bei der die Messmittel (116) in Reihe ein Selektivfilter (117) zum Auswählen des gegebenen Frequenzkanals, einen logarithmischen Detektor (118) und einen Analog-Digital-Wandler (ADC) angeordnet umfassen, um den Pegel des Ausgangssignals (108) in dem gegebenen Frequenzkanal zu liefern.

6. Verfahren zur Bestimmung des Pegels eines durch ein Empfangssystem (TUN) empfangenen Eingangssignals (101), wobei das Empfangssystem (TUN) einen Satz von Verstärkern diskreter Verstärkung (102-103-105-107), ein Selektivfilter (104), eine Mischstufe (106) in Reihe angeordnet aufweist, das Empfangssystem (TUN) ausgebildet ist, ein Ausgangssignal (108) zu liefern, und wobei das Verfahren umfasst:

- einen Messschritt (201) zum Messen des Pegels des Ausgangssignals (108) in einem gegebenen Frequenzkanal,
- einen Verarbeitungsschritt (203) zum Bestimmen der tatsächlichen Verstärkung (G1) des Satzes von Verstärkern (102-103-105-107) in dem gegebenen Frequenzkanal,
- einen ersten Berechnungsschritt (204) zum Bestimmen der tatsächlichen Verstärkung (G2) des Selektivfilters (104) in dem gegebenen Frequenzkanal durch einen Satz von Gleichungen, deren Koeffizienten von einer für jeden Frequenzbereich des Selektivfilters vorgenommenen Kalibrierung abgeleitet sind, und
- einen zweiten Berechnungsschritt (205) zum Ableiten des Pegels des Eingangssignals (101) von dem Pegel des Ausgangssignals (108), von der tatsächlichen Verstärkung (G1) des Satzes von Verstärkern und von der tatsächlichen Verstärkung (G2) des Selektivfilters (104).

7. Empfangsbox für Multimediasignale oder Modem, umfassend eine Einrichtung nach einem der Ansprüche 1 bis 5.

8. Signal, erzeugt durch das Verfahren nach Anspruch 6, wobei das Signal den Pegel des Eingangssignals (101) angibt.

9. Computerprogramm, umfassend Befehlscodes zum Ausführen eines oder einer Vielzahl von Schritten des Verfahrens nach Anspruch 6.


**Revendications**

1. Dispositif permettant de déterminer le niveau d'un signal d'entrée (101) reçu par un système de réception (TUN), ledit système de réception (TUN) comportant, agencés en série, un ensemble d'amplificateurs à valeur de gain discrète (102-103-105-107), un filtre sélectif (104), un mélangeur (106), ledit système de réception (TUN) étant agencé pour délivrer un signal de sortie (108), ledit dispositif comprenant :

- des moyens de mesure (116) permettant de mesurer le niveau dudit signal de sortie (108) dans un canal de fréquences donné,
- des moyens (120) permettant de déterminer le gain réel (G1) dudit ensemble d'amplificateurs (102-103-105-107) dans ledit canal de fréquences donné,

EP 1 547 242 B1

- des moyens (121) permettant de déterminer le gain réel (G2) dudit filtre sélectif (104) dans ledit canal de fréquences donné, par un ensemble d'équations dont les coefficients sont déduits à partir d'un calibrage réalisé pour chaque domaine de fréquences dudit filtre sélectif,
- des moyens de calcul (122) permettant de déduire le niveau du signal d'entrée (101) à partir du niveau du signal de sortie (108), à partir du gain réel (G1) dudit ensemble d'amplificateurs (102-103-105-107) et à partir du gain réel (G2) dudit filtre sélectif (104).

2. Dispositif selon la revendication 1 comprenant des moyens supplémentaires pour établir le niveau moyen dudit signal de sortie (108).

3. Dispositif selon la revendication 2 comportant des moyens supplémentaires pour arrondir le niveau dudit signal d'entrée (101) à la demi valeur la plus proche.

4. Dispositif selon la revendication 3 dans lequel le gain réel (G1) dudit ensemble d'amplificateurs (102-103-105-107) est donné par une table de consultation à deux entrées, une première entrée correspondant audit canal de fréquences donné, une seconde entrée correspondant au gain nominal desdits amplificateurs.

5. Dispositif selon la revendication 4 dans lequel lesdits moyens de mesure (116) comprennent, agencés en série, un filtre sélectif (117) permettant de sélectionner ledit canal de fréquences donné, un détecteur logarithmique (118) et un convertisseur analogique/numérique (ADC) pour délivrer le niveau dudit signal de sortie (108) dans ledit canal de fréquences donné.

6. Procédé pour déterminer le niveau d'un signal d'entrée (101) reçu par un système de réception (TUN), ledit système de réception (TUN) comprenant, agencés en série, un ensemble d'amplificateurs à valeur de gain discrète (102-103-105-107), un filtre sélectif (104), un mélangeur (106), ledit système de réception (TUN) étant agencé en vue de délivrer un signal de sortie (108), ledit procédé comportant :

- une étape de mesure (201) permettant de mesurer le niveau dudit signal de sortie (108) dans un canal de fréquences donné,
- une étape de traitement (203) permettant de déterminer le gain réel (G1) dudit ensemble d'amplificateurs (102-103-105-107) dans ledit canal de fréquences donné,
- une première étape de calcul (204) permettant de déterminer le gain réel (G2) dudit filtre sélectif (104) dans ledit canal de fréquences donné par un ensemble d'équations dont les coefficients sont déduits à partir d'un calibrage effectué pour chaque domaine de fréquences dudit filtre sélectif, et
- une seconde étape de calcul (205) permettant de déduire le niveau du signal d'entrée (101) à partir du niveau du signal de sortie (108), à partir du gain réel (G1) dudit ensemble d'amplificateurs et à partir du gain réel (G2) dudit filtre sélectif (104).

7. Boîtier de réception pour des signaux multimédia, ou modem, comprenant un dispositif tel que revendiqué dans l'une quelconque des revendications 1 à 5.

8. Signal généré par le procédé selon la revendication 6, ledit signal indiquant le niveau du signal d'entrée (101).

9. Programme d'ordinateur comportant des codes d'instruction permettant d'exécuter l'une ou plusieurs des étapes du procédé selon la revendication 6.

8

TUN

FIG.1

FIG.2

FIG.3

**EP 1 547 242 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6107878 A